# EUROPEAN PATENT SPECIFICATION

(11) **EP 1 052 697 B1**
(45) Date of publication and mention of the grant of the patent: **13.07.2011**
(21) Application number: 00109551.2
(22) Date of filing: 04.05.2000
(51) Int. Cl.: H01L 27/146

(54) **Photo diode array**
Photodiodenanordnung
Réseau de photodiodes

(30) Priority: 11.05.1999 JP 12993399
(43) Date of publication of application: 15.11.2000
(60) Divisional application: 10173659.3
(73) Proprietor: Yokogawa Electric Corporation, Tokyo 180-8750 (JP)
(72) Inventor: Komiyama, Makoto, Yokogawa Electric Corp., Musashino-shi, Tokyo 180-8750 (JP); Sanpei, Yoshihito, Yokogawa Electric Corp., Musashino-shi, Tokyo 180-8750 (JP); Miura, Akira, Yokogawa Electric Corp., Musashino-shi, Tokyo 180-8750 (JP); Sakakibara, Katsutoshi, Yokogawa Electric Corp., Musashino-shi, Tokyo 180-8750 (JP); Yakihara, Tsuyoshi, Yokogawa Electric Corp., Musashino-shi, Tokyo 180-8750 (JP); Fujita, Tadashige, Yokogawa Electric Corp., Musashino-shi, Tokyo 180-8750 (JP); Kobayashi, Shinji, Yokogawa Electric Corp., Musashino-shi, Tokyo 180-8750 (JP); Oka, Sadaharu, Yokogawa Electric Corp., Musashino-shi, Tokyo 180-8750 (JP); Akasaka, Yasukazu, Yokogawa Electric Corp., Musashino-shi, Tokyo 180-8750 (JP)
(74) Representative: Henkel, Feiler & Hänzel

(56) References cited:
- EP-A- 0 779 661
- EP-A- 0 851 498
- US-A- 4 775 880
- US-A- 5 712 499
- PATENT ABSTRACTS OF JAPAN vol. 1999, no. 01, 29 January 1999 (1999-01-29) -& JP 10 275906 A (SHIMADZU CORP), 13 October 1998 (1998-10-13)
- PATENT ABSTRACTS OF JAPAN vol. 015, no. 394 (E-1119), 7 October 1991 (1991-10-07) -& JP 03 159168 A (NIPPON STEEL CORP), 9 July 1991 (1991-07-09)
- PATENT ABSTRACTS OF JAPAN vol. 015, no. 412 (E-1124), 21 October 1991 (1991-10-21) -& JP 03 171667 A (SHARP CORP), 25 July 1991 (1991-07-25)

## Description

### 1. Field of the Invention

The present invention relates to a photo diode array, and in particular, to a photo diode array whose linearity can be improved.

### 2. Description of the Prior Art

A photo diode is formed by making a PN junction with a p-type region on the light-receiving surface side and an n-type region on the substrate side, and a current generated by the light incident from the photo sensitive area flows from the cathode to the anode.

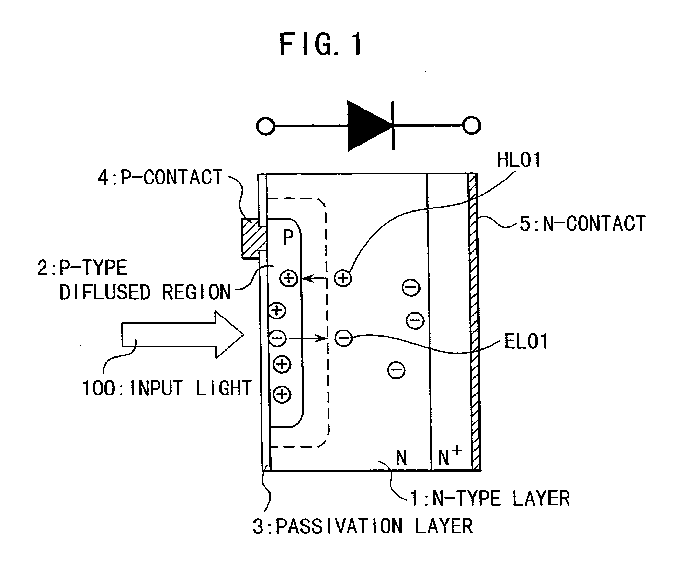

Figure 1 shows a sectional view of the configuration indicating an example of such conventional photo diodes. A p-type diffused region 2 is formed on one side of n-type layer 1, the substrate, n-contact 5 is formed on the opposite side of n-type layer 1, and passivation layer 3 is formed on the light-receiving surface side where p-type diffused region 2 is formed. A p-contact 4 connected to p-type diffused region 2 is formed by removing part of passivation layer 3 using etching or the like.

Operation of a conventional photo diode shown in Figure 1 will be described below. Electrons generated in the photo diode by input light 100 incident from the photo sensitive area are accumulated in n-type layer 1, while holes are accumulated in p-type diffused region 2. Accordingly, n-type layer 1 is negatively charged and p-type diffused region 2 is positively charged. Thus, if an external circuit is connected between p-type diffused region 2 and n-type layer 1, electrons and holes flow toward the opposite layers from n-type layer 1 and p-type diffused region 2 respectively.

For example, an electron generated in p-type diffused region 2 shown as "EL01" in Figure 1 is accelerated towards n-type layer 1 by the electric field in the photo diode and accumulated there. In a similar manner, a hole generated in n-type layer 1 shown as "HL01" in Figure 1 is accelerated towards p-type diffused region 2 and accumulated there.

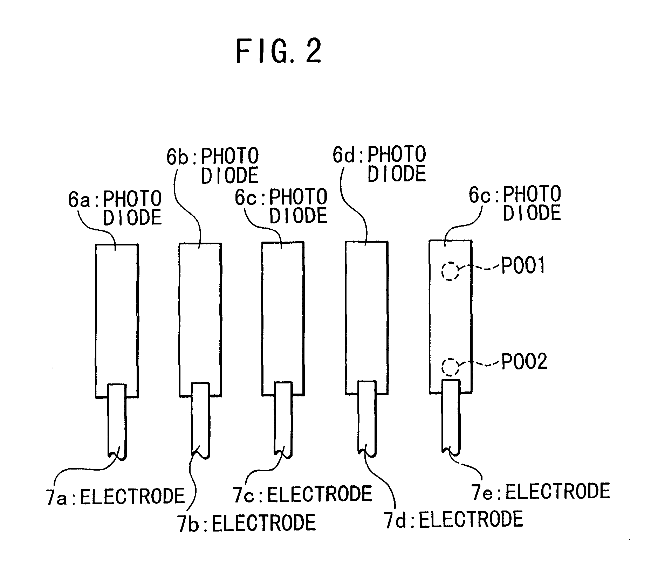

A photo diode array is composed of multiple such photo diodes arranged forming an array. Figure 2 shows a plan indicating an example of such a conventional photo diode array.

Photo diodes 6a to 6e are arranged forming an array on a substrate (not shown) so that their photo sensitive area are oriented to a direction and electrodes 7a to 7e are connected to one end of the photo sensitive area of photo diodes 6a to 6e respectively.

Here, operation of the example of the conventional photo diode array shown in Figure 2 will be described. If light is incident to the photo sensitive area of photo diodes 6a to 6e, currents are generated between each light-receiving surface side and each opposite side and these currents are taken out to the outside via electrodes 7a to 7e, respectively.

For example, in the example shown in Figure 2, holes generated in photo diodes 6a to 6e are taken out via electrodes 7a to 7e.

However, in the example of conventional photo diodes shown in Figure 2, current values taken out may vary due to the incident positions of input light. For instance, if the input light is incident to a portion marked "P001" in Figure 2, the distance from that portion to electrode 7e is longer compared with the case where the input light is incident to the portion marked "P002" in Figure 2.

This causes a voltage drop due to a resistance component that exists between the above portion and the electrode, and so the current value taken out to the outside changes. In other words, a problem exists that linearity deteriorates depending on the incident positions of the input light. Specifically, if a high current is generated by the light incident to the portion marked "P001" in Figure 2, linearity deterioration increases because the generated voltage drop further increases.

In order to reduce this linearity deterioration, a bias voltage forming a reverse bias is generally applied to the photo diode. However, although application of a bias voltage serves to improve the frequency response and linearity, a problem exists that this causes an increase in dark current and so increases the noise, and also has the danger of breaking the photo diode.

US A 5 712 499, JP A 10 275906, and EP A 0 861 498 disclose a photo diode array according to the pre-characterizing part of claim 1.

EP A 0 799 661 teaches electrodes which are lead-out alternately in connection with a photo diode array, however, fails to disclose two electrodes which are connected to both ends of photo sensitive area of one photodiode.

US A 4 775 880 teaches photo conductors and comb-shaped electrodes are arranged on the surface of a device.

JP A 03 159168 discloses plural photo diodes, which are connected to one electrode.

### SUMMARY OF THE INVENTION

The subject of the present invention is to realize a photo diode array in which linearity can be improved.

The above object is achieved by a photo diode array according to claim 1. The dependent claims are directed to different advantageous aspects of the invention.

### BRIEF DESCRIPTION OF THE DRAWINGS

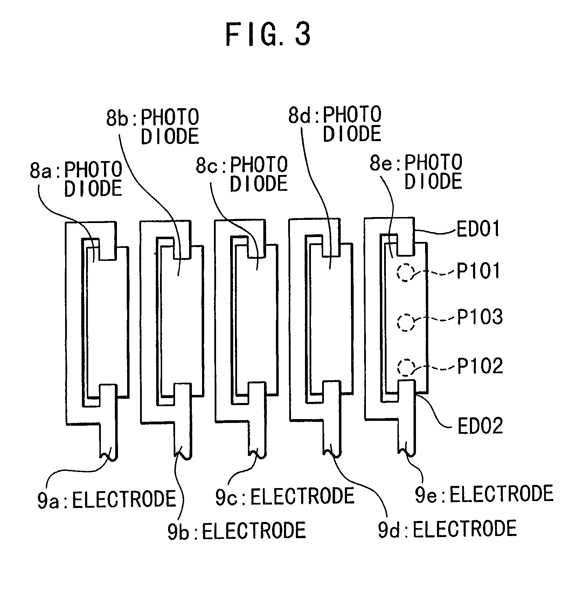

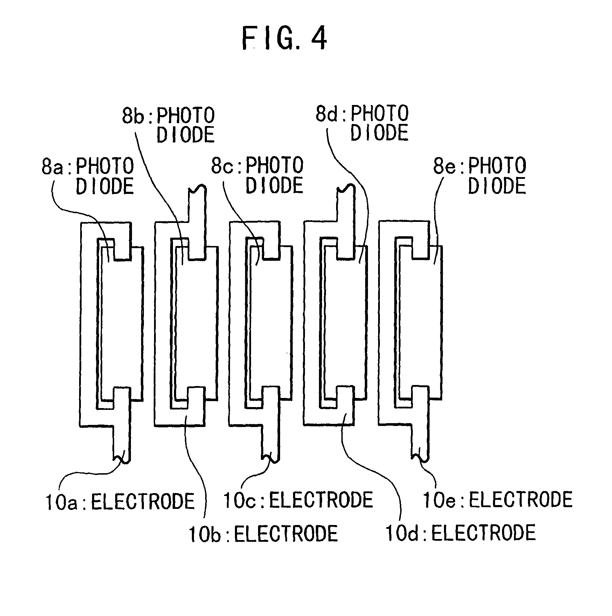

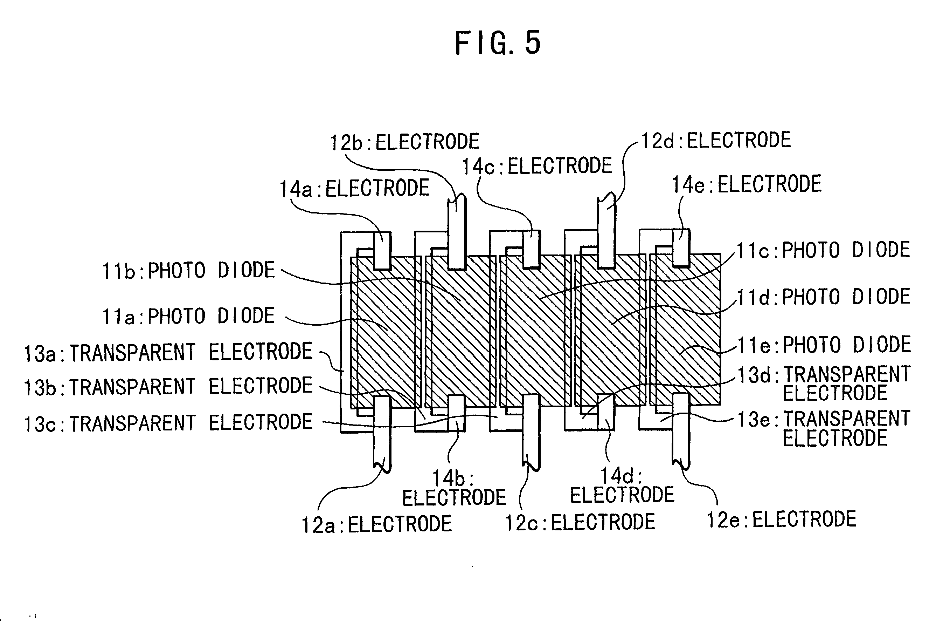

Figure 1 shows a sectional view of the configuration indicating an example of conventional photo diodes. Figure 2 shows a plan indicating an example of conventional photo diode arrays. Figure 3 shows a plan indicating an embodiment of a photo diode array not forming part of, but necessary to understand the present invention. Figure 4 shows a plan indicating the second embodiment of a photo diode array not forming part of, but necessary to understand the present invention. Figure 5 shows a plan indicating the third embodiment of a photo diode array based on the present invention.

### DETAILED DESCRIPTION OF THE PREFERRED EMBODIMENT

The present invention will be described below in detail using drawings. Figure 3 shows a plan indicating an embodiment of photo diode array not forming part of, but necessary to understand the present invention.

Photo diodes 8a to 8e are arranged on a substrate (not shown) forming an array so that their photo sensitive area are oriented to a direction. Electrodes 9a to 9e are connected to one end of the photo sensitive area of photo diodes 8a to 8e respectively and also connected to the other end of the photo sensitive area of photo diodes 8a to 8e respectively by extending the electrodes between the photo sensitive area of two adjacent diodes.

In addition, electrodes 9a to 9e connected to both ends of photo sensitive area photo diodes 8a to 8e respectively are wired on the substrate in a direction downwards in Figure 3 to be led out to the outside.

Operation of the photo diode array of the embodiment shown in Figure 3 will be described. Since this array is configured to take currents out of both ends of each photo sensitive area of photo diodes 8a to 8e, respective distances from incident positions of the input light to electrodes 9a to 9e are shortened compared with those in examples of conventional photo diode arrays. Thus, the effect of resistance components that exist between the electrodes and the corresponding incident positions is reduced. In other words, deterioration of linearity can be reduced.

For example, if the input light is incident to the portion marked "P101" in Figure 3, the distance from the portion of "P101" to electrode 9e is that from the portion of "P101" to the connecting portion marked "ED01" in Figure 3. On the other hand, if the input light is incident to the portion marked "P102" in Figure 3, the distance from the portion of "P102" to electrode 9e is that from the portion of "P102" to the connecting portion marked "ED02" in Figure 3. That is, in both cases where the input light is incident to the portions marked "P101" and "P102" in Figure 3, the distances to electrode 9e are the same.

In addition, even if the input light is incident to the portion located at the center of the photo diode marked "P103," the distance between this portion and electrode 9e becomes approximately 1/2 compared with that in an example of the conventional array shown in Figure 2. Since this distance represents the maximum between the input light incident portion and the electrode in that photo diode, even in the worst case, deterioration of linearity can be reduced by about 1/2.

As a result, adoption of the configuration in which current is taken out of both ends of the photo sensitive area of photo diodes 8a to 8e shortens the distances between the input light incident portions and electrodes 9a to 9e respectively and so enables deterioration of linearity to be reduced.

In the embodiment shown in Figure 3, there is only one lead-out direction of electrodes 9a to 9e (towards the bottom of Figure 3). However, this lead-out can be done in both directions (towards the top and bottom of the figure). Figure 4 shows a plan indicating the second embodiment of a photo diode array not forming part of, but necessary to understand the present invention, in which the electrode lead-out direction is modified.

Photo diodes 8a to 8e are arranged forming an array on a substrate (not shown) so that the light-receiving surfaces face to this side. Electrodes 10a to 10e are connected to one end of the photo sensitive area of photo diodes 8a to 8e respectively as well as connected to the other ends of the photo sensitive area of photo diodes 8a to 8e respectively by extending the electrodes between adjacent photo diodes.

Further, electrodes 10a, 10c, and 10e connected to both ends of the photo sensitive area of photo diodes 8a, 8c, and 8e respectively are extended on the substrate towards the bottom of Figure 4 to be led out to the outside, while electrodes 10b and 10d connected to both ends of the photo sensitive area photo diodes 8b and 8d respectively are extended on the substrate towards the top of Figure 4 to be led out to the outside.

Operation of the photo diode array of the embodiment shown in Figure 4 will be described below. However, the basic operation is the same as in the embodiment shown in Figure 3 and the differences are as follows:

By alternately changing the electrode lead-out direction, wiring to the electrodes becomes easy in the case where it is difficult to secure wiring spaces for the electrodes from which the current signals are led out to the outside because the photo diodes are arranged in a highly dense manner.

In addition, in the embodiment shown in Figure 4, the electrode lead-out direction is changed alternately (every other electrode). However, the method of determining the electrode lead-out direction is not limited to the above but any number of electrodes may be led out in both directions. The lead-out direction may be changed regularly, for example, for every two electrodes, three electrodes, etc. The lead-out direction may also be changed irregularly.

As a result, wiring to the electrodes becomes easy because wiring spaces for the electrodes are secured by leading out the electrodes from both ends of the photo sensitive area of the electrodes.

In another case, the electrodes extended between adjacent photo diodes may be made transparent to secure the photo sensitive area of those portions of the photo diodes. Figure 5 shows a plan indicating the third embodiment of a photo diode array, this embodiment being part of the present invention and using such transparent electrodes in part of the array.

Photo diodes 11a to 11e are arranged forming an array on a substrate (not shown) so that the light-receiving surfaces face to this side. Electrodes 12a to 12e are connected to one end of the photo sensitive area of photo diodes 11a to 11e and electrodes 14a to 14e to the other ends of photo diodes 11a to 11e respectively.

Further, electrodes 12a and 14a are connected to each other by transparent electrode extension 13a located between adjacent photo diodes, and electrodes 12b and 14b are connected to each other by transparent electrode extension 13b located between adjacent photo diodes.

Electrodes 12c, 12d and 12e and electrodes 14c, 14d and 14e are connected to each other respectively by corresponding transparent electrodes 13c, 13d and 13e extended between adjacent photo diodes.

Further, electrodes 12a, 12c and 12e connected to one end of each photo sensitive area of photo diodes 11a, 11c and 11e respectively are wired on the substrate to lead out to the outside towards the bottom of Figure 5. Electrodes 12b and 12d connected to one end of each photo sensitive area of photo diodes 11b and 11d respectively are wired on the substrate to lead out to the outside towards the top of Figure 5.

Operation of the photo diode array of the embodiment shown in Figure 5 will be described below. However, the basic operation is the same as in the embodiment shown in Figure 3 and the differences are as follows:

By making electrodes extended between adjacent photo diodes transparent, the light-receiving areas of the photo diodes can be increased compared with the embodiments shown in Figures 3 and 4 because these transparent electrode extensions may overlap with the photo diodes.

As a result, by employing the transparent electrode extensions between the adjacent photo diodes, it becomes possible to enlarge the photo sensitive area of each photo diode.

In addition, in each embodiment shown in Figures 3, 4 and 5, five photo diodes are shown as an example for simplicity of description. However, the number of photo diodes is, of course, not limited to this number but the present invention can be applied to any photo diode array using any number of photo diodes.

Also, in the embodiments shown in Figures 3, 4 and 5, electrode extensions connecting both ends of the photo sensitive area of photo diodes respectively are passed between the target photo diodes and the next photo diodes on the left side of the target photo diodes respectively. However, electrode extensions connecting both ends of the photo sensitive area of photo diodes respectively may of course be passed between the target photo diodes and the next photo diodes on the right side of the target photo diodes respectively.

Further, in the embodiment shown in Figure 5, an example of electrodes that are led out in both directions alternately is shown. However, the electrodes may of course be led out in one direction only or alternately for every two electrodes in both directions or irregularly in both directions.

As is apparent from the description above, the present invention has the following effects:

According to the invention, the distance between the input light incident position and the electrodes is shortened by employing the configuration in which currents are taken out from both ends of each photo sensitive area of every photo diode. Thus, it becomes possible to reduce deterioration of linearity.

In addition, according to the invention, it becomes possible to increase the photo sensitive area of the photo diode portion by making the electrodes extended between adjacent photo diodes transparent.

According to the invention, wiring to the electrodes becomes easy by leading out the electrodes in both directions from the photo sensitive area of photo diodes because spaces for wiring to the electrodes are secured.

## Claims

1. A photo diode array comprising:
a plurality of photo diodes (11a to 11e) arranged forming an array; and
a plurality of electrodes (12a to 12e, 14a to 14e) that are connected to the photo sensitive area of these photo diodes (11a to 11e) and take out currents generated in the above photo diodes (11a to 11e);
**characterized in that**
each electrode (12a to 12e, 14a to 14e) consists of two connection portions and an electrode extension (13a to 13e) connecting the above two connection portions ;
the electrode extension (13a to 13e) is a transparent electrode extension being located between a photo diode (
11a to 11e) and an adjacent one of said photo diodes (11a to 11e) and connected to the above two connection portions respectively; and
each of the two connection portions (ED01, ED02) is connected to one respective end of the photo sensitive area of the photo diode (11a to 11e).

2. A photo diode array in accordance with claim 1,
**characterized in that** the electrode extensions are located between adjacent photo sensitive areas of the photo diodes (11a to 11e).

3. A photo diode array in accordance with claim 2,
**characterized in that** said transparent electrode is made of indium-tin oxide.

4. A photo diode array in accordance with any one of claims 1 and 2,
**characterized in that** there is only one lead-out direction of said electrodes (9a to 9e), from the photo sensitive area of the photo diodes (11a to 11e).

5. A photo diode array in accordance with any one of claims 1 and 2,
**characterized in that** the lead-out direction of said electrodes (12a to 12e) is in both directions from one end and the other end of said photo sensitive area of the photo diodes (11a to 11e).

6. A photo diode array in accordance with claim 5,
**characterized in that** said electrodes (12a to 12e) are led out alternately in both directions from both ends of said photo sensitive area of the photo diodes (11a to 11e).

7. A photo diode array in accordance with claim 5,
**characterized in that** said electrodes (12a to 12e) are led out repeatedly in the following manner:
in one direction from each end of said photo sensitive area of the photo diodes (11a to 11e), and
next in the other direction from the other end of one of said photo sensitive area of the photo diodes (11a to 11e).

## Patentansprüche

1. Fotodiodenarray mit:
einer Mehrzahl von Fotodioden (11a bis 11e), die unter Bildung eines Arrays angeordnet sind;
einer Mehrzahl von Elektroden (12a bis 12e, 14a bis 14e), die mit dem lichtempfindlichen Gebiet der Fotodioden (11a bis 11e) verbunden sind und Ströme entnehmen, die in den oben genannten Fotodioden (11a bis 11e) erzeugt werden;
**dadurch gekennzeichnet, dass**
jede Elektrode (12a bis 12e, 14a bis 14e) aus zwei Verbindungsabschnitten und einer Elektrodenverlängerung (13a bis 13e) gebildet ist, die die oben genannten zwei Verbindungsabschnitte verbindet;
wobei die Elektrodenverlängerung (13a bis 13e) eine transparente Elektrodenverlängerung ist, die zwischen einer Fotodiode (11a bis 11e) und einer benachbarten Fotodiode (11a bis 11e) angeordnet und mit den oben genannten zwei Verbindungsabschnitten jeweils verbunden ist; und
wobei jeder der zwei Verbindungsabschnitte (ED01, ED02) mit einem jeweiligen Ende des lichtempfindlichen Gebiets der Fotodiode (11a bis 11e) verbunden ist.

2. Fotodiodenarray nach Anspruch 1, **dadurch gekennzeichnet**, das die Elektrodenverlängerungen zwischen benachbarten lichtempfindlichen Gebieten der Fotodioden (11a bis 11e) angeordnet sind.

3. Fotodiodenarray nach Anspruch 2, **dadurch gekennzeichnet**, das die transparente Elektrode aus Indium-Zinnoxid gebildet ist.

4. Fotodiodenarray nach einem der Ansprüche 1 und 2, **dadurch gekennzeichnet**, das es nur eine herausführende Richtung für die Elektroden (9a bis 9e) von dem lichtempfindlichen Gebiet der Fotodiode (11a bis 11e) gibt.

5. Fotodiodenarray nach einem der Ansprüche 1 und 2, **dadurch gekennzeichnet**, das die herausführende Richtung der Elektroden (12a bis 12e) in beide Richtungen von einem Ende und dem anderen Ende des lichtempfindlichen Gebiets der Fotodioden (11a bis 11e) ist.

6. Fotodiodenarray nach Anspruch 5, **dadurch gekennzeichnet**, das die Elektroden (12a bis 12e) herausführende Elektroden abwechselnd in beide Richtungen von beiden Enden des lichtempfindlichen Gebiets der Fotodioden (11a bis 11e) sind.

7. Fotodiodenarray nach Anspruch 5, **dadurch gekennzeichnet**, das die Elektroden (12a bis 12e) jeweils herausführende Elektroden in der folgenden Reihenfolge sind:
in einer Richtung von jedem Ende der lichtempfindlichen Gebiets der Fotodioden (11a bis 11e) und
als nächstes in die andere Richtung von dem anderen Ende von einem der lichtempfindlichen Gebiete der Fotodioden (11a bis 11e).

## Revendications

1. Réseau de photodiodes comprenant :
une pluralité de photodiodes (11a à 11e) agencées de manière à former un réseau ; et
une pluralité d'électrodes (12a à 12e, 14a à 14e) qui sont connectées à la zone photosensible de ces photodiodes (11a à 11e) et qui prélèvent les courants générés dans les photodiodes (11a à 11e) ci-dessus ;
**caractérisé en ce que**
chaque électrode (12a à 12e, 14a à 14e) consiste en deux parties de connexion et une extension d'électrode (13a à 13e) connectant les deux parties de connexion ci-dessus ;
l'extension d'électrode (13a à 13e) est une extension d'électrode transparente qui est située entre une photodiode (11a à 11e) et une photodiode adjacente parmi lesdites photodiodes (11a à 11e) et connectée aux deux parties de connexion ci-dessus, respectivement ; et
chacune des deux parties de connexion (ED01, ED02) est connectée à une extrémité respective de la zone photosensible de la photodiode (11a à 11e).

2. Réseau de photodiodes selon la revendication 1, **caractérisé en ce que** les extensions d'électrode sont situées entre des zones photosensibles adjacentes des photodiodes (11a à 11e).

3. Réseau de photodiodes selon la revendication 2, **caractérisé en ce que** ladite électrode transparente est constituée d'oxyde indium-étain.

4. Réseau de photodiodes selon l'une quelconque des revendications 1 et 2, **caractérisé en ce qu'**il n'y a qu'une seule direction de sortie desdites électrodes (9a à 9e), à partir de la zone photosensible des photodiodes (11a à 11e).

5. Réseau de photodiodes selon l'une quelconque des revendications 1 et 2, **caractérisé en ce que** la direction de sortie desdites électrodes (12a à 12e) est dans les deux directions à partir d'une extrémité et de l'autre extrémité de ladite zone photosensible des photodiodes (11a à 11e).

6. Réseau de photodiodes selon la revendication 5, **caractérisé en ce que** lesdites électrodes (12a à 12e) sont sorties alternativement dans les deux directions à partir des deux extrémités de ladite zone photosensible des photodiodes (11a à 11e).

7. Réseau de photodiodes selon la revendication 5, **caractérisé en ce que** lesdites électrodes (12a à 12e) sont sorties de manière répétée de la manière suivante :
dans une direction à partir de chaque extrémité de ladite zone photosensible des photodiodes (11a à 11e), et
ensuite dans l'autre direction à partir de l'autre extrémité de ladite zone photosensible des photodiodes (11a à 11e).
